# FASCICULE DE BREVET EUROPEEN

(11) **EP 3 375 267 B1**
(45) Date de publication et mention de la délivrance du brevet: **11.03.2020**
(21) Numéro de dépôt: 16805314.8
(22) Date de dépôt: 11.11.2016
(51) Int. Cl.: H05K 7/20, H05K 7/14

(54) **BOITIER POUR UN EQUIPEMENT ELECTRIQUE**
GEHÄUSE FÜR EINE ELEKTRISCHE VORRICHTUNG
HOUSING FOR AN ELECTRICAL APPARATUS

(30) Priorité: 13.11.2015 FR 1560863
(43) Date de publication de la demande: 19.09.2018
(73) Titulaire: Valeo Siemens eAutomotive France SAS, 95800 Cergy (FR)
(72) Inventeur: SANVITO, Guillaume, 78990 Elancourt (FR); SMAL, Pierre, 78500 Sartrouville (FR)
(74) Mandataire: Argyma
(86) Numéro de dépôt international: PCT/EP2016/077440
(87) Numéro de publication internationale: WO 2017/081256

(56) Documents cités:
- EP-A1- 1 863 156
- US-A1- 2006 207 780

## Description

La présente invention concerne un boîtier pour un équipement électrique, et un équipement électrique comprenant un boitier selon l'invention, notamment pour des applications dans le domaine de l'automobile.

On connait un onduleur pour commander une machine électrique embarquée dans un véhicule. La machine embarquée dans le véhicule peut permettre d'entrainer les roues du véhicule. Un tel onduleur peut comprendre une unité électronique de puissance comprenant des composants par lesquels passe l'énergie alimentant la machine électrique ; et une unité électronique de commande comprenant des composants pour contrôler les composants de l'unité électronique de puissance.

On connait également des convertisseurs de tension continu/continu (DC/DC) embarqués dans un véhicule qui réalisent une conversion de tension entre un premier réseau électrique et un deuxième réseau électrique du véhicule. Typiquement, le premier réseau électrique est un réseau basse tension délivrant une tension inférieure à 60V, notamment de 18 ou 12V environ, et le deuxième réseau électrique est un réseau haute tension qui délivre une tension supérieure à 60V, notamment supérieure à 100, 200, voire 400V. Afin de gagner en densité d'intégration dans le véhicule, l'onduleur et le convertisseur DC/DC peuvent être intégrés dans un seul équipement électrique à l'intérieur du véhicule.

L'onduleur et le convertisseur DC/DC subissent un échauffement lié à leur environnement, mais qui est aussi lié aux puissances élevées qui circulent à travers eux lorsque la machine électrique fonctionne à haute tension ou lorsque le convertisseur DC/DC réalise une conversion haute-basse tension.

Afin d'obtenir un refroidissement efficace de l'onduleur et du convertisseur DC/DC, il est connu de prévoir un boitier d'équipement électrique en deux parties dans lequel les composants de l'onduleur et du convertisseur DC/DC sont répartis entre les deux parties, un circuit de refroidissement étant prévu entre les deux parties de boitier. Par exemple, la publication de demande de brevet KR20110139038 A décrit un tel boîtier d'équipement électrique dans lequel un premier boitier comprend les composants de l'onduleur et un deuxième boitier comprend les composants du convertisseur DC/DC. Une paroi du premier boitier vient contre une paroi du deuxième boitier pour définir des canaux de circulation d'un fluide de refroidissement.

Cependant, la réalisation d'un tel boitier en deux parties est complexe et pose des problèmes liés à la tenue de l'étanchéité du circuit de refroidissement ou à l'intégration des composants dans le boitier en deux parties.

L'invention cherche à résoudre au moins en partie les problèmes de l'art antérieur en proposant un Boitier pour un équipement électrique, ledit boitier comprenant :
- un premier logement destiné à recevoir des premiers composants,
- un deuxième logement destiné à recevoir des deuxièmes composants,
- une interface séparant le premier logement du deuxième logement,
- un circuit de refroidissement configuré pour recevoir un fluide destiné à refroidir ledit équipement électrique, ledit circuit de refroidissement étant formé dans ladite interface
boitier dans lequel ladite interface comprend un trou non traversant s'étendant depuis le premier logement vers le deuxième logement configuré pour former une cavité destinée à recevoir un premier composant.

En prévoyant une cavité dans l'interface entre le premier logement et le deuxième logement, on libère de la place dans le premier logement. Cet espace libéré dans le premier composant permet d'améliorer la densité de composant dans le premier logement. En outre, en étant reçu dans une cavité de l'interface, le refroidissement du premier composant est facilité grâce à un drainage thermique par le circuit de refroidissement par l'intermédiaire des parois de la cavité.

Selon un mode de réalisation, l'interface comprend une première surface du côté du premier logement et une deuxième surface opposée à la première surface du côté du deuxième logement, ledit trou s'étendant depuis une première ouverture dans ladite première surface.

Selon un mode de réalisation, ledit trou non traversant est en outre formé par une excroissance s'étendant depuis la deuxième surface.

Selon un mode de réalisation, l'interface comprend dans son épaisseur une première partie formant le circuit de refroidissement et une deuxième partie comprenant ladite cavité, lesdites parties étant sur des côtés respectifs de l'interface.

Selon un mode de réalisation, le boîtier pour un équipement électrique comprend :
- un premier boîtier définissant le premier logement ;
- un deuxième boitier définissant le deuxième logement ;
dans lequel l'interface entre les deux logements est formée par une première paroi du premier boîtier et une deuxième paroi du deuxième boitier venant en appui l'une contre l'autre.

Selon un mode de réalisation, ladite première ouverture est dans la première paroi, la deuxième paroi comprenant une deuxième ouverture configurée pour correspondre avec la première ouverture.

Selon un mode de réalisation, l'excroissance s'étend depuis les bords de la première ouverture et passe par la deuxième ouverture.

Selon un mode de réalisation, I l'excroissance s'étend depuis les bords de la deuxième ouverture.

L'invention concerne également un équipement électrique comprenant :
- un boitier selon l'invention,
- au moins deux premiers composants logés dans le premier logement, l'un étant logé dans ladite cavité, l'autre étant monté sur ladite interface,
- au moins un deuxième composant logé dans le second logement, notamment monté sur la dite interface.

Selon un mode de réalisation, les premiers composants ont des électrodes ayant des parties sensiblement au même niveau par rapport à l'interface, les deux premiers composants étant connectés par un connecteur électrique sensiblement plan.

Selon un mode de réalisation, le premier composant monté sur l'interface comprend des interrupteurs d'un convertisseur de tension ; et le premier composant logé dans ladite cavité comprend une capacité située dans la liaison électrique entre une source d'énergie continue et le convertisseur de tension.

L'invention va être décrite en détail dans la description qui suit en liaison avec les dessins ci-annexés. Il est à noter que ces dessins n'ont d'autre but que d'illustrer le texte de la description et ne constituent en aucune sorte une limitation de la portée de l'invention.
Les figures 1 et 2 sont des vues en perspective d'un exemple d'équipement électrique 1 selon l'invention.
Les figures 3 et 4 sont respectivement des vues d'un premier logement et d'un deuxième logement de l'équipement électrique lorsque les couvercles sont enlevés.
La figure 5 est une vue en coupe de l'équipement électrique.
Les figures 6 et 7 sont des autres vues du premier logement de l'équipement électrique avec certains composants enlevés.
Les figures 8 et 9 sont des vues en coupe du boitier de l'équipement électrique.
Les figures 10 et 11 sont des vues en perspective du premier boitier du boitier de l'équipement électrique.
La figure 12 représente un joint d'étanchéité inséré entre le premier et le deuxième boitier du boitier de l'équipement électrique.
Les figures 13 et 14 sont des vues en perspective du deuxième boitier du boitier de l'équipement électrique.
Les figures 15 à 18 sont d'autres vues en coupe de l'équipement électrique.

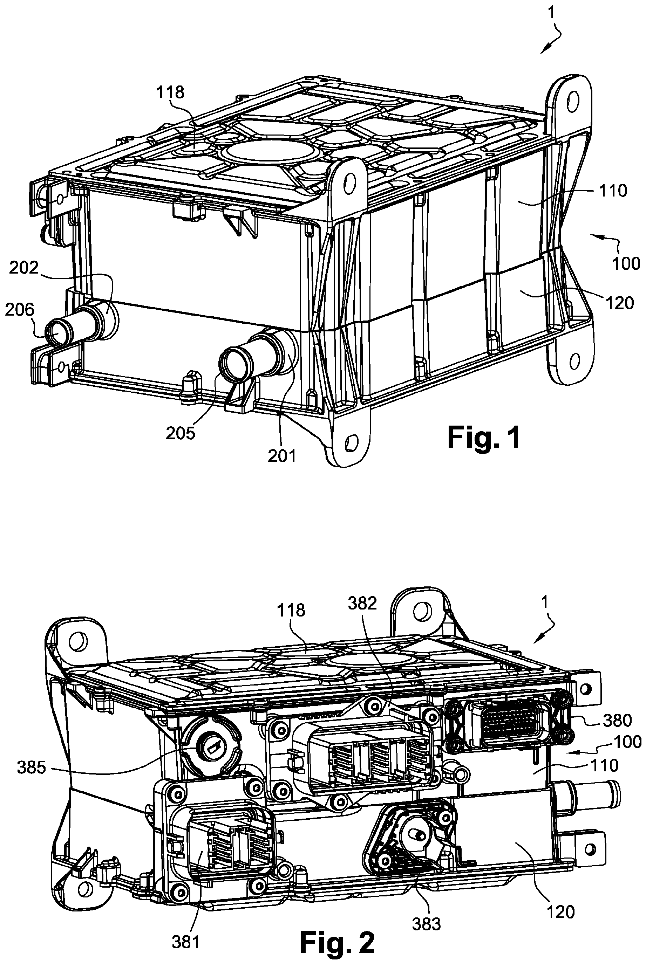

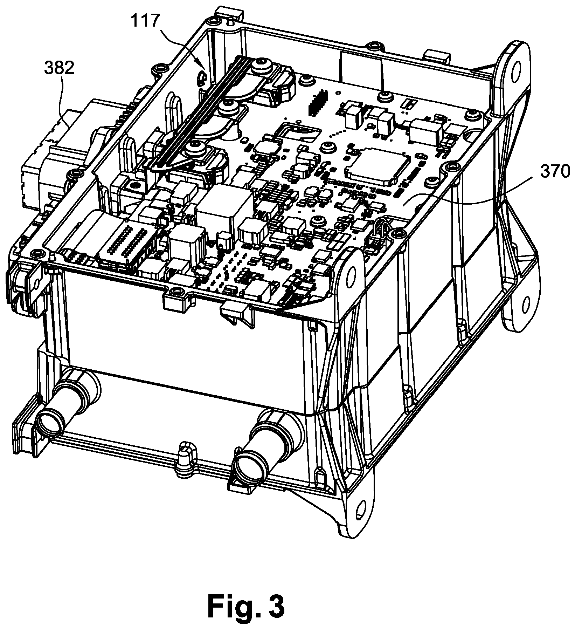

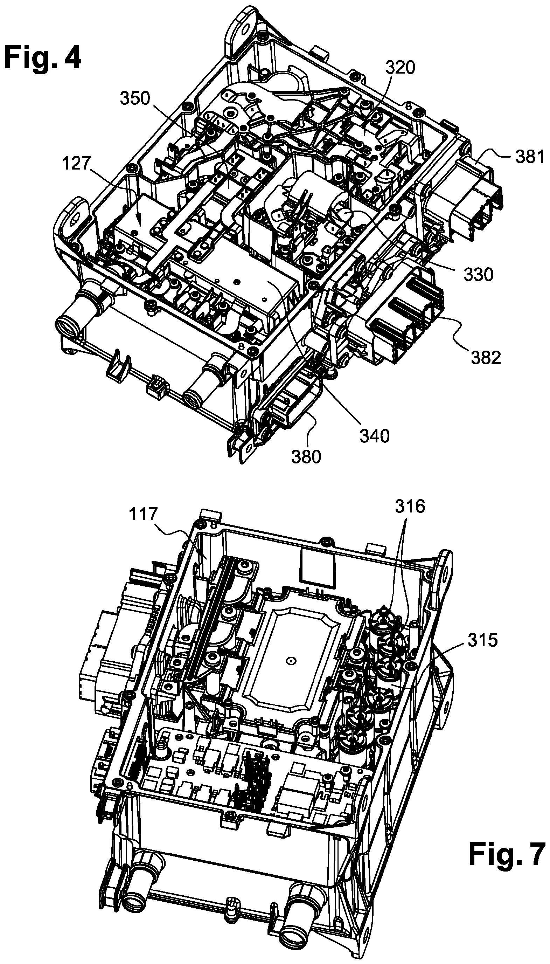

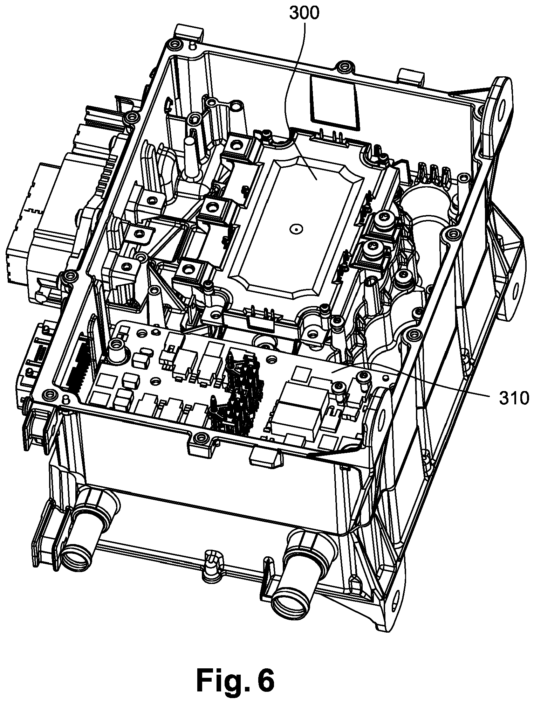

Les figures 1 à 7 et 15 à 18 montrent des vues en perspective ou de coupe d'un exemple d'équipement électrique 1 selon l'invention. L'équipement électrique 1 comprend un boitier 100 qui loge les composants de l'équipement électrique 1. L'équipement électrique 1 comprend notamment un onduleur destiné à alimenter une machine électrique telle qu'une machine électrique tournante, par exemple une machine destinée à entrainer les roues d'un véhicule. L'équipement électrique 1 comprend notamment un convertisseur DC/DC destiné à convertir une tension entre un premier réseau électrique continu et un deuxième réseau électrique continu du véhicule.

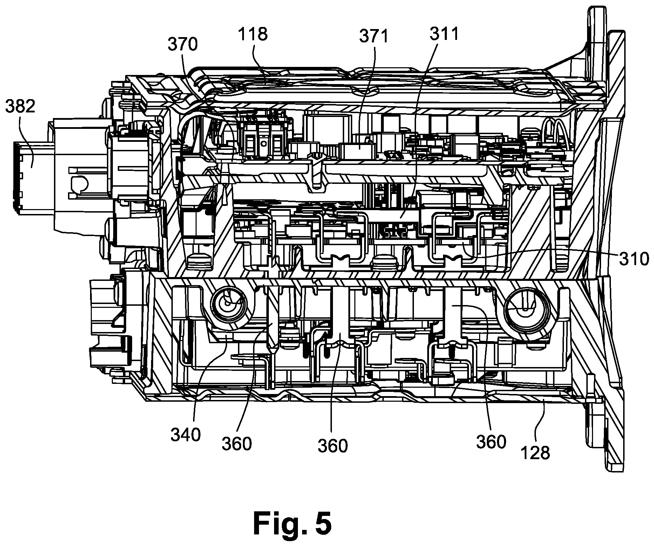

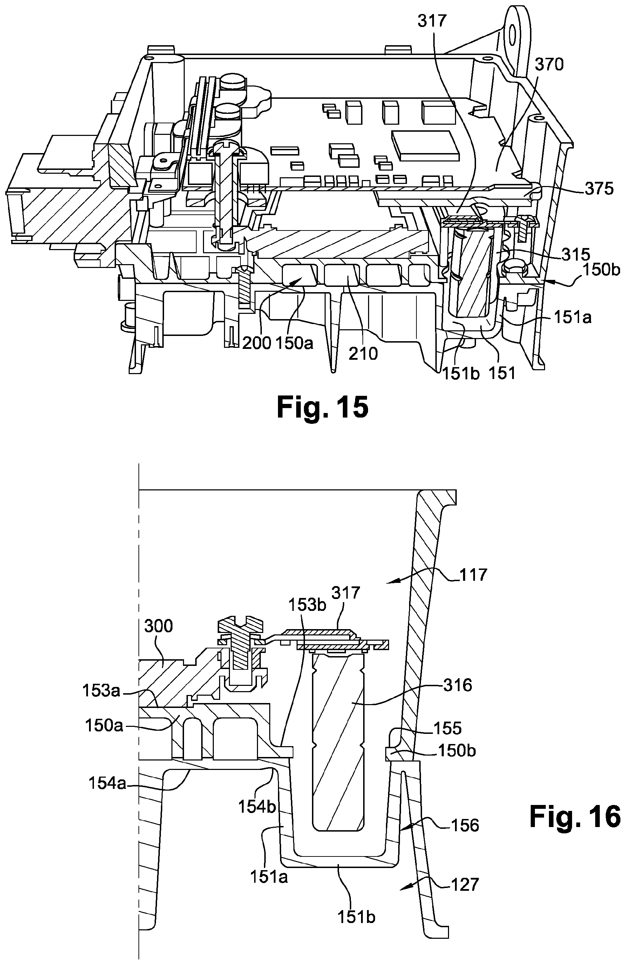

Le boitier 100 de l'équipement électrique comprend un premier logement 117 qui reçoit des premiers composants 300, 310, 315, 370, 375, notamment des composants électroniques, et un deuxième logement 127 qui reçoit des deuxièmes composants 320, 330, 340, 350, notamment des composants électroniques. Une interface 150, visible en figures 5, 8 et 15 sépare le premier logement 117 du deuxième logement 127. L'interface 150 comprend un circuit de refroidissement 200 qui permet de refroidir les composants de l'équipement électrique 1 grâce notamment à la circulation d'un fluide de refroidissement dans des canaux 210 du circuit de refroidissement 200. Comme illustré en figure 15, l'interface 150 comprend un trou non traversant qui forme une cavité 151 qui reçoit un premier composant 315.

Le premier composant 315 peut être maintenu dans la cavité 151 par de la colle entre le composant 315 et une paroi, notamment une paroi de fond 151a, de la cavité 151. Une résine peut remplir l'espace entre la périphérie du composant 315 et les parois 151a, 151b de la cavité 151 de manière à limiter les vibrations vis-à-vis du premier composant 315 et le maintenir en place. En prévoyant le premier composant 315 dans la cavité 151, de l'espace dans le premier logement 117 est libéré qui permet de faciliter l'intégration des autres premiers composants 300, 310, 370, 375 dans le premier logement 117. En outre, les parois 151a, 151b de la cavité 151 améliorent la dissipation thermique du premier composant 315.

La figure 16 montre une vue en coupe agrandie de l'équipement électrique 1. En particulier, l'interface 150 comprend une première surface 153 située du côté du premier logement 117. Une deuxième surface 154 de l'interface 150 est opposée à la première surface 153 et est située du côté du deuxième logement 127. Le trou traversant qui forme la cavité 151 s'étend depuis une première ouverture 155 située dans la première surface 153. Le premier composant 315 est notamment introduit dans la cavité 151 par la première ouverture 155. Ainsi, la portion du composant 315 qui dépasse de la cavité 151 a une hauteur inférieure à la hauteur du premier composant 315. L'espace occupé par le premier composant 315 dans le premier logement 117 est donc inférieur à celui qu'il occuperait s'il était positionné sur la première surface 153, ce qui libère de la place pour l'intégration d'autres premiers composants.

Une excroissance 156 peut s'étendre depuis la deuxième surface 154 de manière à définir le trou non traversant formant la cavité 151. La cavité 151 s'étend donc partiellement dans le deuxième logement 127 du boitier 100 de l'équipement électrique 1. Ainsi, la profondeur de la cavité 151 n'est pas limitée par l'épaisseur de l'interface 150, notamment l'épaisseur entre la première surface 153 et la deuxième surface 154. En particulier, l'excroissance 156 comprend une paroi qui s'étend depuis la deuxième surface 154 de manière à former la paroi latérale 151a de la cavité 151. Notamment, la paroi latérale 151a s'aligne le long des bords de la première ouverture 155. Une paroi relie l'extrémité distale de la paroi latérale 151a de manière à former une paroi de fond 151b de la cavité 151. La paroi de fond 151b est plane ou a une forme curviligne.

Le circuit de refroidissement 200 peut être formé dans une première partie 150a de l'interface 150. Une deuxième partie 150b comprend la cavité 151. Les deux parties 150a, 150b sont sur des côtés respectifs de l'interface 150. En particulier, la première partie 150a et la deuxième partie 150b s'étendent chacune de la première surface 153 à la deuxième surface 154, et sont séparées par une frontière s'étendant de la première surface 153 à la deuxième surface 154. Autrement dit, la cavité 151 n'est pas comprise dans le circuit de refroidissement 200, ce qui simplifie la conception de l'interface 150.

La première surface 153 et la deuxième surface 154 peuvent être planes. En particulier, la portion 153a de la première surface 153 située dans la première partie 150a de l'interface 150 peut être plane, à l'exception de rainures pour améliorer la rigidité ou d'excroissances 157 (visible en figure 5) qui réalisent un support de fixation, notamment pour un ou des premiers composants. La portion 153b de la première surface 153 située dans la deuxième partie 150b de l'interface 150 peut elle aussi être plane. Une marche peut séparer la portion 153a de la première surface 153 située dans la première partie 150a et la portion 153b de la première surface 153 située dans la deuxième partie 150b. Cette marche est due à l'épaisseur de l'interface 150 qui est plus importante dans la première portion 150 pour définir le circuit de refroidissement 200.

La deuxième surface 154, en particulier la portion 154a de la deuxième surface 154 située dans la première partie 150a de l'interface 150 et la portion 154b de la deuxième surface 154 située dans la deuxième partie 150b de l'interface 150, peuvent présenter des caractéristiques similaires à celles décrites ci-dessus. Cependant, la deuxième surface 154 ne présente pas nécessairement de marche, en particulier lorsque l'interface 150 est formée par deux boitiers 110, 120 et qu'une première gorge 112, formant le circuit de refroidissement 200 avec une deuxième gorge 122, a une épaisseur plus importante que la deuxième gorge 122, comme il sera expliqué par la suite.

La deuxième partie 150b de l'interface 150 peut en outre comprendre des passages pour le positionnement de connecteurs électriques 360 (visibles en figure 5) qui réalisent une connexion électrique entre les premiers et les deuxièmes composants à travers l'interface 150.

Le circuit de refroidissement 200 peut comprendre un port d'entrée 201 et un port de sortie 202 par lesquels le fluide de refroidissement entre et sort du circuit de refroidissement 200.

Selon un mode de réalisation, le boitier 100 de l'équipement électrique 1 comprend un premier boitier 110 qui définit le premier logement 117 et un deuxième boitier 120 qui définit le deuxième logement 127. Le premier boitier 110 reçoit le ou les premiers composants de l'équipement électrique 1. Le deuxième boitier 120 reçoit le ou les deuxièmes composants de l'équipement électrique 1.

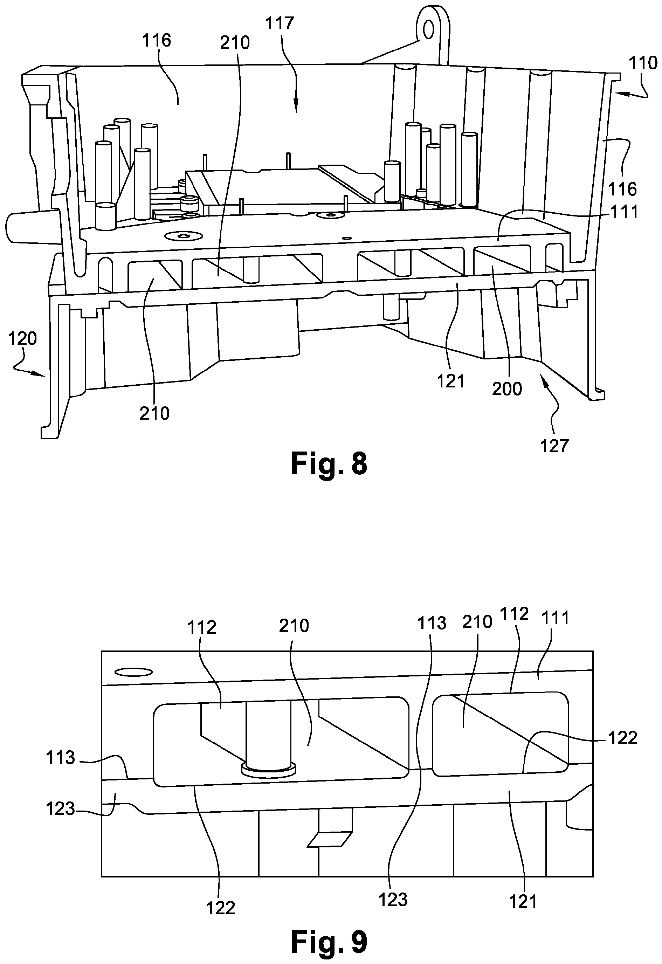

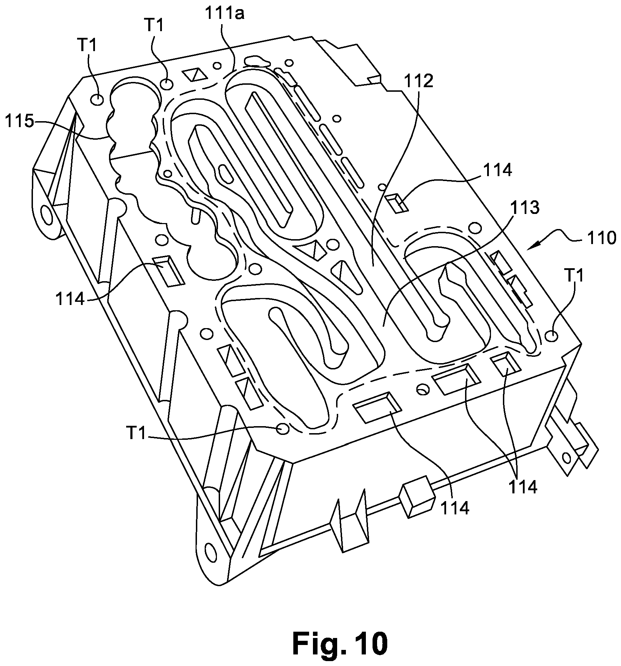

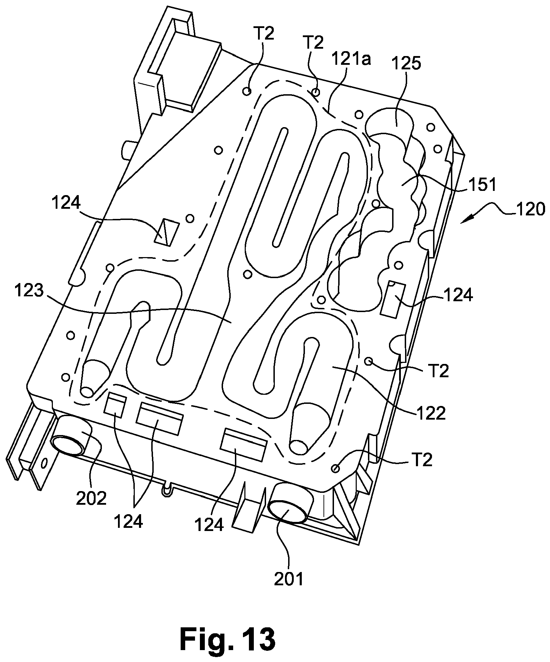

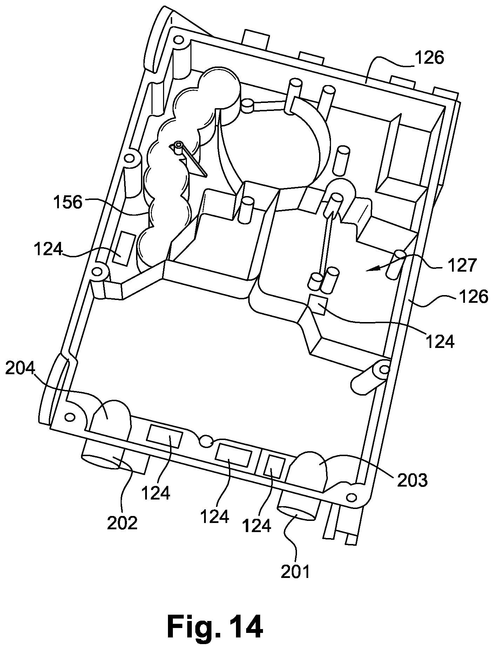

Des exemples de premier 110 et deuxième 120 boitiers sont illustrés en figures 8 à 14. Le premier boîtier 110 comprend une première paroi 111 qui vient en appui avec une deuxième paroi 121 du deuxième boitier 120 pour former l'interface 150 entre le premier logement 117 et le deuxième logement 127. La première 110 et la deuxième 120 parois forment en particulier le circuit de refroidissement 200.

La première paroi 111 peut comprendre une gorge 112 qui vient en vis-à-vis avec une gorge 122 de la deuxième paroi 120 pour former le circuit de refroidissement 200. La première surface 153 de l'interface 150 correspond à la face de la première paroi 111 qui est opposée à la face portant la première gorge 112 ; et la deuxième surface 154 de l'interface 150 correspond à la face de la deuxième paroi 121 qui est opposée à la face portant la deuxième gorge 122.

En particulier, la première gorge 112 et la deuxième gorge 122 viennent en vis-à-vis pour former un canal 210 du circuit de refroidissement dans lequel va circuler le fluide de refroidissement. Ainsi, le diamètre du canal de refroidissement est réparti entre les deux parois. Cela permet de répartir entre les deux parois les contraintes sur l'épaisseur de paroi qui sont dues à la formation du circuit de refroidissement 200 et d'équilibrer entre eux le logement 117 défini par le premier boitier 110 et le logement 127 défini par le deuxième boitier 120.

En particulier, la première 111 ou la deuxième 121 parois peuvent en outre comprendre des ouvertures traversantes au niveau du circuit de refroidissement 200. Ces ouvertures sont obstruées par une plaque rapportée sur la paroi 111, 121 après montage du premier boiter 110 et du deuxième boiter 120 l'un sur l'autre. Une telle plaque est par exemple constituée par une partie d'un composant électrique monté sur la paroi 111, 121. Alternativement, le circuit de refroidissement est intégralement formé par la première 112 et la deuxième gorge 122. Autrement dit, les canaux de refroidissement 210 sont formés uniquement par les gorges 112, 122. Notamment, les première 111 et deuxième 121 parois sont chacune des pièces d'un seul tenant.

En particulier, la première paroi 111 et la deuxième paroi 121 viennent l'une contre l'autre au niveau de surfaces sensiblement planes respectives 113, 123, dites surfaces d'appui. La surface d'appui 113 de la première paroi 111 comprend les bords de la première gorge 112 ; et la surface d'appui 123 de la deuxième paroi 121 comprend les bords de la deuxième gorge 122. On entend par bord de la première 112 ou de la deuxième 122 gorges, la frontière entre la gorge 112, 122 et la surface depuis laquelle la gorge 112,122 se creuse. La surface depuis laquelle la première gorge 112 se creuse correspond notamment à la surface d'appui 113 de la première paroi 111 ; et la surface depuis laquelle la deuxième gorge 122 se creuse correspond notamment à la surface d'appui 123 de la deuxième paroi 121. En particulier, les bords de la première 112 ou deuxième 122 gorges sont intégralement compris dans leur surface d'appui 113, 123 respective.

En prévoyant des surfaces d'appui planes entre la première 111 et la deuxième paroi 121, on facilite la mise en oeuvre de l'étanchéité du circuit de refroidissement 200. En effet, les parties de la première paroi 111 et de le deuxième paroi 121 qui viennent l'une contre l'autre pour former le circuit de refroidissement 200 sont de préférence usinées pour éliminer des irrégularités de surface qui pourraient créer des espaces de fuite du fluide de refroidissement hors du circuit de refroidissement 200. En prévoyant des surfaces de contact 113, 123 planes on facilite l'usinage de ces surfaces d'appui 113, 123.

En outre, il est préférable que seules les surfaces d'appui 113, 123 des parois 111, 121 soient usinées et pas les zones qui sont en contact avec le fluide de refroidissement telles que les gorges 112, 122. En effet, en usinant les gorges 112, 122 on risquerait de mettre à jour des porosités dans la matière de la première 111 ou deuxième 121 paroi. Lors de la circulation du fluide de refroidissement, celui-ci risquerait de s'infiltrer dans la paroi 111, 121 par l'intermédiaire de ces porosités jusqu'à fuir à travers la première paroi 111 ou la deuxième paroi 121. En prévoyant, que le circuit de refroidissement 200 est formé par la première gorge 112 dans la première paroi et par la deuxième gorge 122 dans la deuxième paroi 121 on facilite l'usinage. Dans un boitier de l'art antérieur, où la première paroi est plane et ne comprend pas de gorge, il faut pratiquer un usinage sélectif qui n'usine que les parties de la première paroi qui sont destinées à venir en contact avec la deuxième paroi en évitant les parties de la première paroi qui sont destinées à être en contact avec le fluide de refroidissement, car définissant une partie du canal de refroidissement. L'usinage se fait donc avec une tête de polissage dont le diamètre est inférieur ou égal à la distance entre deux canaux de passage du fluide de refroidissement. Pour le boitier de l'équipement électrique 1 illustré, l'outil d'usinage peut avoir une tête de polissage de diamètre supérieure à la distance entre deux canaux de passage du fluide de refroidissement car la tête de polissage ne sera en contact qu'avec la surface d'appui 113. On peut donc usiner plus de surface avec la tête de polissage, ce qui diminue le temps d'usinage. On évite également la mise en œuvre d'un parcours complexe de la tête de polissage pour un usinage sélectif.

En outre, la première paroi 111 peut être dépourvue d'excroissances s'étendant au-delà de sa surface d'appui 113 et la deuxième paroi 121 peut être dépourvue d'excroissances s'étendant au-delà de sa surface d'appui 123, au moins dans les zones 111a, 121a des parois 111, 121 qui forment le circuit de refroidissement 200. Cela facilite encore le passage d'un seul outil d'usinage sur la face de la première paroi 111 et de celle de la deuxième paroi 121 qui vont venir former le circuit de refroidissement 200. A noter que la zone 111a de la première paroi 111 et la zone 121a de la deuxième paroi 121 qui forment le circuit de refroidissement 200 correspondent à la première portion 150a de l'interface 150.

La profondeur de la première gorge 112 peut être plus grande que celle de la deuxième gorge 122. En particulier, la première gorge 112 a une profondeur comprise entre 5 et 20mm, notamment égale à 10mm ; et la deuxième gorge 122 a une profondeur comprise entre 0,5 et 1mm, notamment égale à 1mm. Cette différence de profondeur entre la première gorge 112 et la deuxième gorge 122 permet de limiter l'épaisseur de la deuxième paroi 122 pour obtenir plus d'espace dans le deuxième logement 127.

Le trou non traversant formant la cavité 151 est notamment formé lors de la mise en appui de la première paroi 111 contre la deuxième paroi 121. En particulier, la première ouverture 155 de l'interface 150 correspond à une première ouverture 115 dans la première paroi 111. La deuxième paroi 121 comprend une deuxième ouverture 125. Les bords de la première ouverture 115 de la première paroi 111 correspondent avec les bords de la deuxième ouverture 125 de la deuxième paroi 121 lors de la mise en appui de la première paroi 111 contre la deuxième paroi 121.

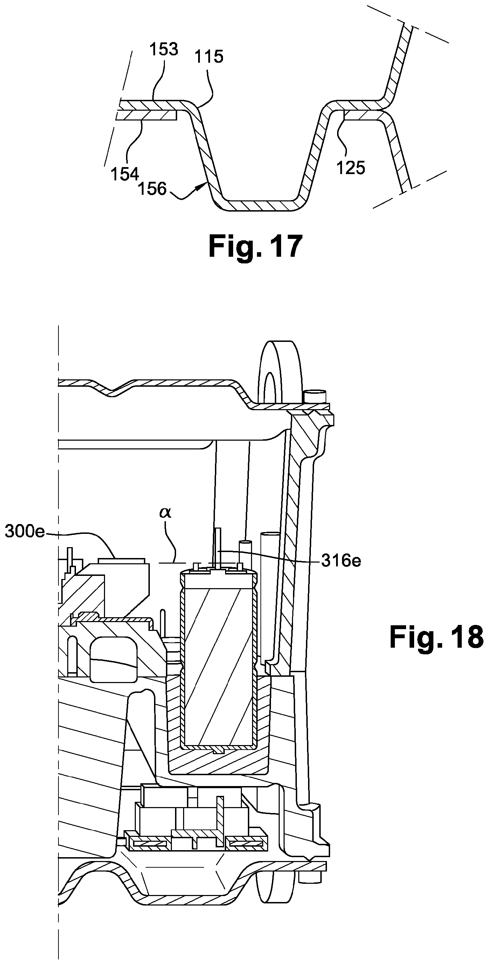

Comme illustré en figure 16, la première ouverture 115 de la première paroi 111 peut être traversante et la deuxième ouverture 125 de la deuxième paroi 121 peut être non traversante. L'excroissance 156 formant la cavité 151 s'étend depuis les bords de la deuxième ouverture 125, depuis la deuxième surface 154 de l'interface 150. Cependant, le trou non traversant pourrait être obtenu d'une autre manière. Par exemple, la figure 17 représente schématiquement un exemple dans lequel la première ouverture 115 de la première paroi 111 n'est pas traversante et la deuxième ouverture 125 de la deuxième paroi 121 est traversante. L'excroissance 156 s'étend depuis les bords de la première ouverture 115 de la première paroi 111. Cependant, l'exemple de la figure 17 est moins compact que celui en figure 16.

La première paroi 111 peut comprendre au moins un trou traversant 114 et la deuxième paroi 121 peut comprendre au moins un trou traversant 124, dont les bords viennent en contact l'un sur l'autre pour former un passage entre le premier logement 117 et le deuxième logement 127. En particulier, ces trous traversants 114, 124 forment un passage entre la première surface 153 et la deuxième surface 154 de l'interface 150. Ces trous traversants 114, 124, sont notamment formés à l'extérieur des zones 111a, 121a des première 111 et deuxième 121 parois qui forment le circuit de refroidissement 200. Le passage formé par ces trous traversants 114, 124 permet le positionnement des connecteurs électriques 360 qui réalisent la connexion électrique entre les premiers et les deuxièmes composants à travers l'interface 150.

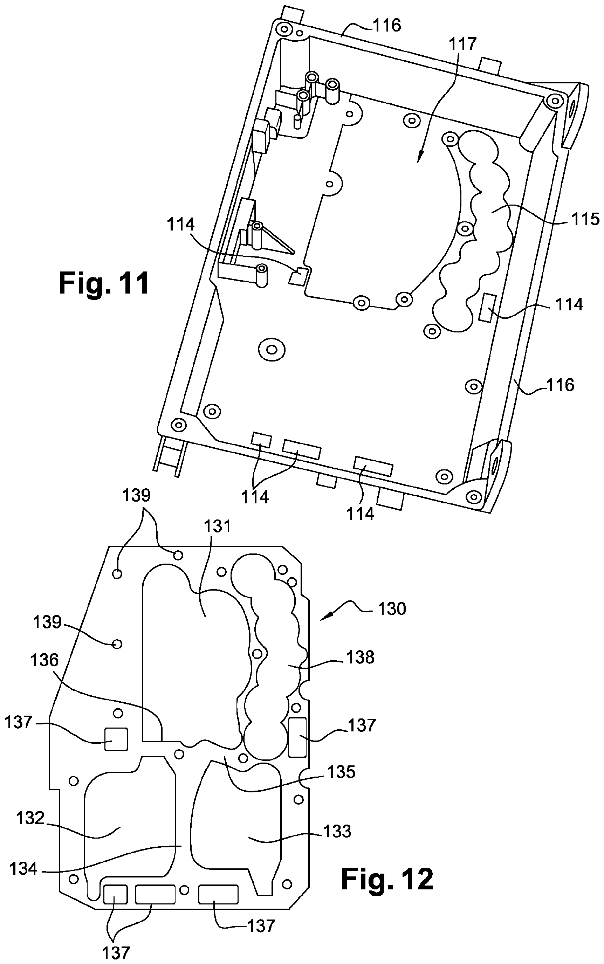

Un joint d'étanchéité peut être positionné entre la première paroi 111 et la deuxième paroi 121. Un exemple de joint d'étanchéité 130 est illustré en figure 12. Le joint d'étanchéité 130 réalise en particulier une étanchéité autour des zones 111a, 121a des première 111 et deuxième 121 parois qui forment le circuit de refroidissement 200. A cet effet, le joint d'étanchéité 130 vient notamment entre les surfaces d'appui 113, 123 de la première paroi 111 et de la deuxième paroi 121. Le joint d'étanchéité 130 peut être dépourvu de matière dans une partie qui se situe dans le circuit de refroidissement 200 lorsqu'il est formé, à l'exception de bandes de matière 134, 135,136. Ces bandes de matière 134, 135, 136 améliorent la rigidité du joint d'étanchéité 130 de manière à faciliter la manutention et le placement du joint d'étanchéité 130. Ces bandes de matière 134, 135,136 peuvent avoir des largeurs juste suffisantes pour obtenir une rigidité et définissent des ouvertures 131, 132, 133. Le joint d'étanchéité 130 réalise une étanchéité le long d'une ligne fermée autour du circuit de refroidissement 200, notamment autour des zones 111a, 121a des parois 111, 121 qui forment le circuit de refroidissement 200, c'est-à-dire autour de la première portion 150a de l'interface 150. Le joint d'étanchéité 130 peut également réaliser l'étanchéité autour des passages formés dans la première paroi 111 et la deuxième paroi 121. Le joint d'étanchéité 130 comprend alors des trous 137 dont les bords réalisent l'étanchéité autour desdits passages. Le joint d'étanchéité 130 peut aussi comprendre des trous 139 qui permettent le passage d'organes de fixation respectifs pour la fixation de la première paroi 111 sur la deuxième paroi 121. Un trou 138 dans le joint d'étanchéité permet le passage du premier composant 315.

Notamment, les ports d'entrée 201 et de sortie 202 du circuit de refroidissement 200 sont compris dans le deuxième boitier 120, en particulier dans une paroi latérale 126 du deuxième boitier 120 décrite ci-après. Notamment, les ports d'entrée/sortie 201, 202 sont des ouvertures tubulaires dans la paroi latérale 116. Ces ports d'entrées/sorties 201,202 sont prolongés par des tubes 203, 204 qui communiquent avec la deuxième gorge 122 de la deuxième paroi 121 pour y acheminer ou y extraire le fluide de refroidissement. Les ports d'entrée/sortie 201, 202 auraient pu être compris de manière similaire dans le premier boitier 110. En prévoyant les ports d'entrée/sortie 201,202 dans un seul des deux boitiers 110, 120, on simplifie la mise en oeuvre de l'étanchéité au niveau des ports d'entrée/sortie 201, 202. Alternativement, les ports d'entrée/sorties 201, 202 auraient pu comprendre une première partie issue du premier boitier 110 et une deuxième partie issue du deuxième boitier 120, les deux parties venant l'une contre l'autre lorsque le circuit de refroidissement 200 est formé. Des embouts 205, 206 peuvent être insérés dans les ports d'entrée/sortie 201, 202 pour les adapter à un circuit d'alimentation en fluide de refroidissement.

Chaque boitier 110, 120 peut comprendre des parois latérales respectives 116, 126 qui s'étendent transversalement depuis la périphérie de la première 111 ou de la deuxième 121 paroi de manière à définir respectivement le premier logement 117 et le deuxième logement 127. En particulier, lorsque les premier 110 et deuxième 120 boitiers sont montés l'un sur l'autre de manière à former le circuit de refroidissement 200, les parois latérales 116 du premier boitier 110 s'étendent dans une direction opposée par rapport au deuxième boitier 120 et les parois latérales 126 du deuxième boitier 120 s'étendent dans une direction opposée par rapport au premier boitier 110. Chaque logement 117, 127 peut être fermé par un couvercle respectif 118, 128 qui vient contre les extrémités distales des dites parois latérales 116, 126. Ainsi, la première paroi 111 forme un fond du premier boitier 110 et la deuxième paroi 121 forme un fond du deuxième boitier 120.

Le premier boitier 110 et le deuxième boitier 120 peuvent être fixés l'un à l'autre par des organes de fixation qui maintiennent la première paroi 111 en appui contre la deuxième paroi 121. Ces organes de fixation sont par exemple des vis s'introduisant dans des trous correspondants T1, T2 dans la première paroi 111 et la deuxième paroi 121. Les organes de fixation peuvent être aussi des clips, par exemple portés par les parois latérales 116,126 du premier boitier 110 et du deuxième boiter 120.

Selon un mode de réalisation, le premier logement 117 de l'équipement électrique 1 comprend le premier composant 315 logé dans la cavité 151 et d'autres premiers composants 300, 310 montés sur l'interface 150. En outre, le deuxième logement 127 de l'équipement électrique 1 comprend un ou plusieurs deuxièmes composants 320, 330, 340, 350. En particulier, les deuxièmes composants 320, 330, 340, 350 sont montés sur l'interface 150.

Par exemple, le premier logement 117 peut comprendre un module électronique de puissance 300 faisant parti de l'onduleur. Le module électronique de puissance 300 comporte des composants destinés à alimenter la machine électrique. Le premier logement 117 peut comprendre une carte électronique à substrat métallique isolée (SMI ou « Insulated Molded Substrate » en anglais) 310 faisant parti du convertisseur DC/DC. La carte SMI porte des composants pour la conversion de tension entre le premier et le deuxième réseau électrique du véhicule. Ces modules électroniques de puissance 300 et la carte SMI 310 peuvent être supportées par la première surface 153 de l'interface 150, notamment la première paroi 111, avec une de leur face venant en contact avec la première surface 153, notamment avec la première paroi 111. En particulier, le module électronique de puissance 300, ou la carte SMI 310 peuvent être situés au moins en partie sur la portion 153a de la première surface 153 qui est située dans la première partie 150a (partie de refroidissement), ce qui améliore leur refroidissement. Les composants du module de puissance 300 ou de la carte SMI comprennent par exemple des interrupteurs électroniques, tels que des transistors semiconducteurs, ou autres.

Le premier logement 117 peut en outre comprendre une unité électronique de contrôle 370 et un support 375 de l'unité électronique de contrôle 370. Le support 375 de l'unité électronique de contrôle 370 est une plaque qui est suspendue dans le premier logement 117. Par exemple, la plaque est maintenue en place en venant en appui contre des portions de matière du premier boitier 110, notamment des excroissances 157 issues de la première surface 153 de l'interface 150. La plaque 375 est notamment maintenue en place en venant en appui au niveau de sa périphérie. L'unité électronique de contrôle est notamment une carte électronique 370 sur laquelle les composants 371 sont montés. L'unité électronique de contrôle 370 est supportée par le support 375 par l'intermédiaire d'une face en contact avec le support 375. En particulier, l'unité électronique de contrôle 370 contrôle les composants de l'onduleur et du convertisseur DC/DC, notamment les composants du module électronique de puissance 300 et de la carte SMI 310.

Le premier composant 315 logé dans la cavité 151 peut être un bloc capacitif 315 qui comprend plusieurs condensateurs 316. Il est connecté à l'onduleur, notamment au module électronique de puissance 300, et au convertisseur DC/DC, notamment à la carte SMI 310. En particulier, le bloc capacitif 315 est dans la liaison électrique entre, d'une part le premier réseau électrique du véhicule, et d'autre part l'onduleur et le convertisseur DC/DC, notamment le module électronique de puissance 300 et la carte SMI 310. Le bloc capacitif 315 constitue une réserve d'énergie au plus proche du module électronique de puissance 300 et de la carte SMI 310, notamment pour un découpage par leurs interrupteurs. A cet effet, le bloc capacitif 315 est connecté au module de puissance 300 et à la carte SMI par une barre de connexion électrique (non représentée). En prévoyant le bloc capacitif 315 dans la cavité 151, de l'espace dans le premier logement 117 est libéré qui permet de faciliter l'intégration des autres premiers composants 300, 310, 370 dans le premier logement. En particulier, cela laisse de la place pour positionner l'unité électronique contrôle 370 et son support 375 au plus près du module électronique de puissance 300 et de la carte SMI 310. Cela limite la longueur des interconnexions entre d'une part l'unité électronique de contrôle 370 et d'autre part le module électronique de puissance 300 et la carte SMI 310.

Par exemple, le bloc capacitif 315 peut être logé dans la cavité 151 de sorte que les électrodes 316e de ses condensateurs 316 sont au moins en partie au même niveau a que les électrodes 300e du module électronique de puissance 300 et les électrodes de la carte SMI 310. Le niveau a est visible par exemple en figure 18. Le niveau s'apprécie suivant une direction perpendiculaire à partir de la première surface 153 de l'interface 150, notamment à partir de la portion 153b de la première surface 153 qui est située dans la deuxième portion 150b de l'interface 150. Ainsi, les électrodes 316e, 300e des condensateurs peuvent être reliées entre elles par un connecteur plan 317, visible en figure 15. On évite donc les plis dans le connecteur 317, ce qui permet de gagner en compacité. L'inductance du connecteur plan peut être limitée en superposant ses traces électriques positive et négative.

Par exemple, le deuxième logement 127 peut comprendre un filtre de compatibilité électromagnétique (ou EMC) 320 pour filtrer un signal d'entrée de l'équipement électrique 1, et/ou un filtre EMC 330 pour filtrer un signal de sortie de l'équipement électrique 1, et/ou un composant magnétique 340 comportant une inductance pour la rectification d'un courant délivré au module de puissance 300 et un transformateur pour le convertisseur DC/DC de l'équipement électrique 1 et/ou un module capacitif 350 destiné à permettre un commutation à zéro de tension (ou ZVS) des commutateurs électriques compris dans le module électronique 300 et/ou sur la carte SMI 310. Ces deuxièmes composants 320, 330, 340, 350 peuvent être supportés par la deuxième surface 154 de l'interface 150, notamment par la deuxième paroi 121, avec une de leur face venant en contact avec la deuxième surface 154 de l'interface 150, notamment avec la première paroi 121. Dans la mesure du possible, les deuxièmes composants 320, 330, 340, 350 peuvent être situés au moins en partie sur la portion 154a de la deuxième surface 154 qui est située dans la première partie 150a (partie de refroidissement), ce qui améliore leur refroidissement.

Les premiers composants 300, 310 peuvent être reliés électriquement avec les deuxièmes composants 320, 330, 340, 350 par l'intermédiaire des connecteurs électriques 360 positionnés dans les passages définis dans l'interface 150. La figure 5 illustre un exemple de connexion électrique entre un connecteur électrique 311 de la carte SMI 310 et une borne du composant magnétique 340 par l'intermédiaire d'un connecteur électrique 360.

Selon un mode de réalisation, les interrupteurs électroniques de l'onduleur et du convertisseur DC/DC de l'équipement électrique 1 sont logés dans l'un des deux boitiers 110, 120 alors que les composants de filtrage et de redressement 320, 330, 340, 350 de l'équipement électrique 1 sont logés dans l'autre des deux boitiers. Cela permet de partager les composants de filtrage entre l'onduleur et le convertisseur DC/DC. En outre, en logeant les interrupteurs dans un même boitier, il est plus facile de les contrôler avec une seule unité électronique de contrôle 370. En particulier, les interrupteurs électroniques de l'onduleur et du convertisseur DC/DC de l'équipement électrique 1 sont logés dans le premier boitier 110 alors que les composants de filtrage et de redressement 320, 330, 340, 350 de l'équipement électrique 1 sont logés dans le deuxième boitier 120.

L'équipement électrique 1 peut comprendre un connecteur signal 380 destiné à permettre un échange de signal de données entre les composants de l'équipement électrique 1 et l'extérieur de l'équipement électrique, par exemple avec un contrôleur du véhicule. L'équipement électrique 1 peut comprendre un connecteur d'entrée de puissance 381 qui permet l'alimentation électrique des composants de l'équipement électrique 1. En particulier, le connecteur d'entrée de puissance 381 permet une connexion électrique avec un premier réseau électrique du véhicule, notamment avec une unité de stockage électrique de ce premier réseau électrique, pour fournir une énergie électrique en entrée de l'onduleur et/ou du convertisseur DC/DC de l'équipement électrique 1. Un connecteur de sortie de puissance 382 peut permettre de transférer une énergie électrique entre l'onduleur de l'équipement électrique 1 et les phases de la machine électrique contrôlée par l'onduleur. Un connecteur électrique de sortie DC/DC 383 peut permettre de transférer une énergie électrique entre le convertisseur DC/DC de l'équipement électrique 1 et un deuxième réseau électrique du véhicule, notamment avec une unité de stockage électrique de ce deuxième réseau électrique. Le premier réseau électrique est par exemple un réseau haute tension et le deuxième réseau électrique est par exemple un réseau basse tension. Ces connecteurs électriques 380, 381, 382, 383 sont notamment sur un côté du boitier 100 de l'équipement électrique 1 illustré en figure 2. En particulier, ces connecteurs électriques 380, 381, 382, 383 sont sur des parois latérales 116, 126 du premier 110 et du deuxième 120 boitiers.

L'équipement électrique 1 peut comprendre un évent 385 pour contrôler l'humidité à l'intérieur de l'équipement électrique 1. L'évent 385 est notamment porté sur un côté du boitier 100 de l'équipement électrique 1. Par exemple, il est porté sur une paroi latérale 116 du premier boitier 110. Il pourrait aussi être porté sur une paroi latérale 126 du deuxième boitier 126.

Le boitier 100 de l'équipement électrique 1, en particulier le premier boitier 111 et le deuxième boitier 121, est en un matériau métallique, par exemple en aluminium ou en alliage d'aluminium.

L'invention ne se limite pas au seul exemple décrit ci-dessus. Les figures représentent un exemple particulier de réalisation qui combine plusieurs modes de réalisation. Cependant, les caractéristiques liées aux modes de réalisation peuvent-être indépendantes entre elles d'un mode à l'autre, ou combinées entre elles, comme cela ressort des revendications. En particulier, le premier composant logé dans la cavité 151 peut être un composant autre que le bloc capacitif 315.

## Revendications

1. Boitier (100) pour un équipement électrique, ledit boitier (100) comprenant :
- un premier logement (117) destiné à recevoir des premiers composants (300, 310, 370, 315),
- un deuxième logement (127) destiné à recevoir des deuxièmes composants (320, 330, 340, 350),
- une interface (150) séparant le premier logement (117) du deuxième logement (127),
- un circuit de refroidissement (200) configuré pour recevoir un fluide destiné à refroidir ledit équipement électrique, ledit circuit de refroidissement (200) étant formé dans ladite interface (150)
boitier (100) dans lequel ladite interface (150) comprend un trou non traversant s'étendant depuis le premier logement (117) vers le deuxième logement (127) configuré pour former une cavité (151) destinée à recevoir un premier composant (315).

2. Boitier (100) pour un équipement électrique selon la revendication 1, dans lequel l'interface (150) comprend une première surface (153) du côté du premier logement (117) et une deuxième surface (154) opposée à la première surface (153) du côté du deuxième logement (127), ledit trou s'étendant depuis une première ouverture (155, 115) dans ladite première surface (153).

3. Boitier (100) pour un équipement électrique selon la revendication 2, dans lequel ledit trou non traversant est en outre formé par une excroissance (156) s'étendant depuis la deuxième surface (154).

4. Boitier (100) pour un équipement électrique selon l'une des revendications précédentes, dans lequel l'interface (150) comprend dans son épaisseur une première partie (150a) formant le circuit de refroidissement (200) et une deuxième partie (150b) comprenant ladite cavité (151), lesdites parties étant sur des côtés respectifs de l'interface (150).

5. Boitier (100) pour un équipement électrique selon l'une des revendications précédentes comprenant :
- un premier boîtier (110) définissant le premier logement (117) ;
- un deuxième boitier (120) définissant le deuxième logement (127) ;
dans lequel l'interface (150) entre les deux logements (117, 127) est formée par une première paroi (111) du premier boîtier (110) et une deuxième paroi (121) du deuxième boitier (120) venant en appui l'une contre l'autre.

6. Boitier (100) pour un équipement électrique selon les revendications 5 et 2, dans lequel ladite première ouverture (115) est dans la première paroi (111), la deuxième paroi (121) comprenant une deuxième ouverture (125) configurée pour correspondre avec la première ouverture (115).

7. Boitier (100) pour un équipement électrique selon la revendication précédente et la revendication 3, dans lequel l'excroissance (156) s'étend depuis les bords de la première ouverture (115) et passe par la deuxième ouverture (125).

8. Boitier (100) pour un équipement électrique selon les revendications 6 et 3, dans lequel l'excroissance (156) s'étend depuis les bords de la deuxième ouverture (125).

9. Equipement électrique (1) comprenant :
- un boitier (100) selon l'une des revendications précédentes,
- au moins deux premiers composants (300, 310, 315) logés dans le premier logement (117), l'un (315) étant logé dans ladite cavité (151), l'autre (300, 310) étant monté sur ladite interface (150),
- au moins un deuxième composant (320, 330, 340, 350) logé dans le second logement (127), notamment monté sur la dite interface (150).

10. Equipement électrique (1) selon la revendication précédente, dans lequel les premiers composants (300, 315) ont des électrodes (300e, 316e) ayant des parties sensiblement au même niveau (a) par rapport à l'interface (150), les deux premiers composants (300, 315) étant connectés par un connecteur électrique (317) sensiblement plan.

11. Equipement électrique (1) selon la revendication 9 ou 10 dans lequel le premier composant (300, 310) monté sur l'interface (150) comprend des interrupteurs d'un convertisseur de tension ; et le premier composant (315) logé dans ladite cavité (151) comprend une capacité (316) située dans la liaison électrique entre une source d'énergie continue et le convertisseur de tension.

## Patentansprüche

1. Gehäuse (100) für eine elektrische Vorrichtung, wobei das Gehäuse (100) umfasst:
- eine erste Aufnahme (117), die zum Aufnehmen der ersten Komponenten (300, 310, 370, 315) bestimmt ist,
- eine zweite Aufnahme (127), die zum Aufnehmen der zweiten Komponenten (320, 330, 340, 350) bestimmt ist,
- eine Schnittstelle (150), die die erste Aufnahme (117) von der zweiten Aufnahme (127) trennt,
- einen Kühlkreis (200), der konfiguriert ist, um ein Fluid aufzunehmen, das zum Kühlen der elektrischen Vorrichtung bestimmt ist, wobei der Kühlkreis (200) in der Schnittstelle (150) ausgebildet ist,
wobei die Schnittstelle (150) in dem Gehäuse (100) ein nicht durchgängiges Loch umfasst, das sich ab der ersten Aufnahme (117) in Richtung der zweiten Aufnahme (127) erstreckt, das konfiguriert ist, um einen Hohlraum (151) zu bilden, der zur Aufnahme einer ersten Komponente (315) bestimmt ist.

2. Gehäuse (100) für eine elektrische Vorrichtung nach Anspruch 1, wobei die Schnittstelle (150) eine erste Oberfläche (153) auf der Seite der ersten Aufnahme (117) und eine zweite Oberfläche (154) gegenüber der ersten Oberfläche (153) auf der Seite der zweiten Aufnahme (127) umfasst, wobei sich das Loch ab einer ersten Öffnung (155, 115) in die erste Oberfläche (153) erstreckt.

3. Gehäuse (100) für eine elektrische Vorrichtung nach Anspruch 2, wobei das nicht durchgängige Loch ferner von einer Ausstülpung (156) gebildet ist, die sich ab der zweiten Oberfläche (154) erstreckt.

4. Gehäuse (100) für eine elektrische Vorrichtung nach einem der vorangehenden Ansprüche, wobei die Schnittstelle (150) in ihrer Stärke einen ersten Abschnitt (150a) umfasst, der den Kühlkreis (200) bildet, und einen zweiten Abschnitt (150b), der den Hohlraum (151) umfasst, wobei die Abschnitte auf jeweiligen Seiten der Schnittstelle (150) sind.

5. Gehäuse (100) für eine elektrische Vorrichtung nach einem der vorangehenden Ansprüche, umfassend:
- ein erstes Gehäuse (110), das die erste Aufnahme (117) definiert;
- ein zweites Gehäuse (120), das die zweite Aufnahme (127) definiert;
wobei die Schnittstelle (150) zwischen den zwei Aufnahmen (117, 127) von einer ersten Wand (111) des ersten Gehäuses (110) und einer zweiten Wand (121) des zweiten Gehäuses (120) gebildet ist, die sich aneinander abstützen.

6. Gehäuse (100) für eine elektrische Vorrichtung nach den Ansprüchen 5 und 2, wobei die erste Öffnung (115) in der ersten Wand (111) ist, wobei die zweite Wand (121) eine zweite Öffnung (125) umfasst, die konfiguriert ist, um mit der ersten Öffnung (115) übereinzustimmen.

7. Gehäuse (100) für eine elektrische Vorrichtung nach vorangehendem Anspruch und Anspruch 3, wobei sich die Ausstülpung (156) ab den Rändern der ersten Öffnung (115) erstreckt und durch die zweite Öffnung (125) verläuft.

8. Gehäuse (100) für eine elektrische Vorrichtung nach den Ansprüchen 6 und 3, wobei sich die Ausstülpung (156) ab den Rändern der zweiten Öffnung (125) erstreckt.

9. Elektrische Vorrichtung (1), umfassend:
- ein Gehäuse (100) nach einem der vorangehenden Ansprüche,
- mindestens zwei erste Komponenten (300, 310, 315), die in der ersten Aufnahme (117) untergebracht sind, wobei eine (315) in dem Hohlraum (151) untergebracht ist, wobei die andere (300, 310) auf der Schnittstelle (150) angebracht ist,
- mindestens eine zweite Komponente (320, 330, 340, 350), die in der zweiten Aufnahme (127) untergebracht, insbesondere auf der Schnittstelle (150) angebracht, ist.

10. Elektrische Vorrichtung (1) nach vorangehendem Anspruch, wobei die ersten Komponenten (300, 315) Elektroden (300e, 316e) haben, die Abschnitte etwa auf demselben Niveau (α) in Bezug auf die Schnittstelle (150) haben, wobei die zwei ersten Komponenten (300, 315) durch einen etwa ebenen elektrischen Verbinder (317) verbunden sind.

11. Elektrische Vorrichtung (1) nach Anspruch 9 oder 10, wobei die erste Komponente (300, 310), die auf der Schnittstelle (150) angebracht ist, Schalter eines Spannungskonverters umfasst; und die erste Komponente (315), die in dem Hohlraum (151) untergebracht ist, eine Kapazität (316) umfasst, die sich in der elektrischen Verbindung zwischen einer kontinuierlichen Energiequelle und dem Spannungskonverter befindet.

## Claims

1. Housing (100) for an electrical apparatus, said housing (100) comprising:
- a first compartment (117) designed to house the first components (300, 310, 370, 315),
- a second compartment (127) designed to house the second components (320, 330, 340, 350),
- an interface (150) separating the first compartment (117) and the second compartment (127),
- a cooling circuit (200) configured to circulate a fluid used to cool said electrical apparatus, said cooling circuit (200) being formed in said interface (150),
housing (100) in which said interface (150) comprises a non-through-hole that extends from the first compartment (117) to the second compartment (127), and configured to form a cavity (151) used to house a first component (315).

2. Housing (100) for an electrical apparatus according to claim 1, in which the interface (150) comprises a first surface (153) on the side of the first compartment (117) and a second surface (154) facing the first surface (153), on the side of the second compartment (127), said hole extending from a first opening (155, 115) in said first surface (153).

3. Housing (100) for an electrical apparatus according to claim 2, in which said non through-hole is also formed by a protrusion (156) that extends from the second surface (154).

4. Housing (100) for an electrical apparatus according to any of the preceding claims, in which the interface (150) comprises in its thickness a first part (150a) that forms the cooling circuit (200) and a second part (150b) that comprises said cavity (151), said parts being on the respective sides of the interface (150).

5. Housing (100) for an electrical apparatus according to any of the preceding claims, and that comprises:
- a first housing (110) that defines the first compartment (117);
- a second housing (120) that defines the second compartment (127);
in which the interface (150) between the two compartments (117, 127) is formed by a first wall (111) of the first housing (110) and a second wall (121) of the second housing (120), resting against one another.

6. Housing (100) for an electrical apparatus according to claims 5 and 2, in which said first opening (115) is in the first wall (111), the second wall (121) comprising a second opening (125) configured to correspond to the first opening (115).

7. Housing (100) for an electrical apparatus according to claim 3, in which the protrusion (156) extends from the sides of the first opening (115) and passes through the second opening (125).

8. Housing (100) for an electrical apparatus according to claims 6 and 3, in which the protrusion (156) extends from the sides of the second opening (125).

9. Electrical apparatus (1) comprising:
- a housing (100) according to one of the preceding claims,
- at least two first components (300, 310, 315) housed in the first compartment (117), one (315) being housed in said cavity (151), and the other (300, 310) being mounted on said interface (150),
- at least a second component (320, 330, 340, 350) housed in the second compartment (127), specifically mounted on said interface (150).

10. Electrical apparatus (1) according to the preceding claim, in which the first components (300, 315) have electrodes (300e, 316e) having parts that are largely at the same level (α) as the interface (150), the two first components (300, 315) being connected by a largely flat electrical connector (317).

11. Electrical apparatus (1) according to claim 9 or 10, in which the first component (300, 310) mounted on the interface (150) comprises the switches of a voltage converter; and the first component (315) housed in said cavity (151) comprises a capacitor (316) located in the path of the electric connection between a source of direct current and the voltage converter.
